# EUROPÄISCHE PATENTSCHRIFT

(11) **EP 1 700 130 B1**
(45) Veröffentlichungstag und Bekanntmachung des Hinweises auf die Patenterteilung: **19.09.2012**
(21) Anmeldenummer: 04797869.7
(22) Anmeldetag: 12.11.2004
(51) Int. Cl.: G01R 21/133

(54) **ENERGIEZÄHLERANORDNUNG**
ENERGY METERING SYSTEM
SYSTEME DE COMPTAGE D'ENERGIE

(30) Priorität: 30.12.2003 DE 10361664
(43) Veröffentlichungstag der Anmeldung: 13.09.2006
(73) Patentinhaber: Austriamicrosystems AG, 8141 Unterpremstätten (AT)
(72) Erfinder: FRITZ, Gerhard, A-8020 Graz (AT); SCHMALZL, Erwin, A-8010 Graz (AT)
(74) Vertreter: Epping - Hermann - Fischer
(86) Internationale Anmeldenummer: PCT/EP2004/012879
(87) Internationale Veröffentlichungsnummer: WO 2005/066643

(56) Entgegenhaltungen:
- EP-A1- 1 538 450
- GB-A- 2 319 345
- US-A- 4 408 283
- US-A- 5 017 860
- US-A1- 2003 011 353
- US-A1- 2003 042 886
- US-B1- 6 373 415
- US-B1- 6 377 037
- NAGURA H ET AL: "Correction method for a single chip power meter" INSTRUMENTATION AND MEASUREMENT TECHNOLOGY CONFERENCE, 1994. IMTC/94. CONFERENCE PROCEEDINGS. 10TH ANNIVERSARY. ADVANCED TECHNOLOGIES IN I & M., 1994 IEEE HAMAMATSU, JAPAN 10-12 MAY 1994, NEW YORK, NY, USA,IEEE, 10. Mai 1994 (1994-05-10), Seiten 1313-1316, XP010121767 ISBN: 0-7803-1880-3

## Beschreibung

Die vorliegende Erfindung betrifft eine Energiezähleranordnung.

Energiezähler dienen zur Erfassung von verbrauchter oder erzeugter elektrischer Energie. Solche Energiezähler werden auch als Stromzähler oder Kilowattstundenzähler bezeichnet.

Bei elektronisch arbeitenden Energiezählern werden normalerweise Spannung und Strom erfaßt, digitalisiert und miteinander multipliziert. Nach der Multiplikation steht die momentane elektrische Leistung bereit. Integriert oder akkumuliert man diese elektrische Leistung über der Zeit, so erhält man ein Signal, welches ein Maß für die in einem bestimmten Zeitintervall erzeugte oder verbrauchte elektrische Energie ist.

Um zu elektrischer Spannung und elektrischem Strom proportionale Signale zu erhalten, können Spannungsteiler, Spannungswandler, Stromwandler oder andere Mittel zur Signalauskopplung verwendet werden.

Bei vielen Anwendungen ist es erforderlich, zumindest in einem der beiden Kanäle zur Erfassung von Spannung und Strom eine galvanische Trennung vorzusehen. Eine solche galvanische Trennung der Stromkreise stellt beispielsweise ein Transformator bereit.

Problematisch bei derartigen Transformatoren ist jedoch die von der induktiven Kopplung des Transformators verursachte Phasenverschiebung. Die Phasenverschiebung ergibt sich zum einen zwischen dem Ausgangssignal und dem Eingangssignal des Transformators. Zum anderen ergibt sich die Phasenverschiebung aber auch zwischen dem den Strom und dem die Spannung repräsentierenden Signal. Dadurch werden jedoch unerwünschte Meßfehler bei der Multiplikation von Spannung und Strom verursacht. Zu beachten ist hierbei, daß Spannung und Strom meist nicht als Gleichsignale, sondern vielmehr als Wechselstromsignale mit mehr oder weniger harmonischer Signalform vorliegen.

Die beschriebene Problematik wird noch zusätzlich dadurch verschärft, daß selbst dann, wenn in Spannungs- und Strom-Meßkanal jeweils ein transformatorischer Übertrager eingesetzt wird, dennoch eine nicht vorhersehbare Phasenverschiebung zwischen beiden Eingangskanälen durch Fertigungstoleranzen, Temperatureffekte, Alterungseffekte oder anderes verursacht werden kann.

Zur Korrektur der beschriebenen, unerwünschten Phasenverschiebung könnten beispielsweise RC-Netzwerke, welche Widerstände und Kondensatoren umfassen, verwendet werden. Diese müssen jedoch normalerweise als zusätzliche externe Komponenten ausgeführt werden und können normalerweise mit Nachteil nicht integriert werden. Zudem wird die Problematik der fertigungs- und temperaturbedingten Toleranzen dadurch nicht grundsätzlich gelöst.

In dem Dokument US 2003/0042886 A1 ist ein Stromzähler angegeben, der eine Erfassung von Strom und Spannung mit nachfolgender Digitalisierung vorsieht. Digitale Filterkoeffizienten werden abhängig von einer Phasenverschiebung bestimmt, die ebenfalls in der digitalen Domäne ermittelt wird.

Das Dokument GB 2 319 345 A betrifft ebenfalls einen Stromzähler. Spannung und Strom werden digitalisiert und miteinander multipliziert zur Bestimmung von Wirk- und Blindleistung. Nach der Multiplikation erfolgt eine Kompensation von Phasenfehlern einerseits der Wirkleistung und andererseits der Blindleistung.

Aufgabe der vorliegenden Erfindung ist es, eine mit geringem Aufwand integrierbare Energiezähleranordnung zu schaffen, bei der die Spannung und/oder der Strom mit galvanischer Trennung erfaßt werden können, ohne daß dadurch Meßfehler entstehen.

Erfindungsgemäß wird die Aufgabe gelöst durch eine Energiezähleranordnung, aufweisend die Merkmale des Patentanspruchs 1.

Gemäß dem vorgeschlagenen Prinzip wird eine Phasenverschiebung zwischen dem Eingang der Energiezähleranordnung, an dem ein von einer elektrischen Spannung abgeleitetes Signal zugeführt wird, und demjenigen Eingang der Energiezähleranordnung, an dem ein von einem elektrischen Strom abgeleitetes Signal zugeführt wird, erfaßt und kompensiert. Die Signaleingänge zum Zuführen des von der Spannung abgeleiteten Signals und des von dem Strom abgeleiteten Signals können auch als Eingangskanäle, nämlich Spannungskanal und Stromkanal, bezeichnet werden.

Mit der vorgeschlagenen Messung und Kompensation der Phasenverschiebung zwischen beiden Kanälen ist es mit Vorteil möglich, die Kanäle voneinander und/oder zumindest einen Eingang von der Energiezähleranordnung galvanisch zu isolieren. Durch den Abgleich der Phasenverschiebung werden Meßfehler der Anordnung vermieden. Dabei sind mit Vorteil keinerlei externe Kompensationsnetzwerke wie Widerstands-Kapazitätsnetzwerke zur Phasenverschiebung erforderlich.

Der Phasenauswertungsblock sowie der Phasenkorrekturblock bewirken mit Vorteil ohne externe Komponenten eine sogenannte On-Chip-Phasenkorrektur der Energiezähleranordnung.

Beispielsweise kann in einer Kalibrier-Betriebsart die Phasenabweichung zwischen beiden Eingangskanälen dadurch gemessen werden, daß ein identisches Eingangssignal an beide Eingänge angelegt wird. Bevorzugt wird ein Sinus-Signal an beide Eingänge der Energiezähleranordnung in der Kalibrier-Betriebsart angelegt.

Dabei können mit Vorteil beispielsweise die Null-Durchgänge beider Signale mit dem Phasenauswertungsblock verglichen werden. Somit ist es möglich, den relativen zeitlichen Abstand der Null-Durchgänge voneinander zu bestimmen. Die Berechnung des Phasenunterschieds aus dem zeitlichen Abstand der Null-Durchgänge der beiden Signale kann mit Vorteil beispielsweise durch eine Logik-Einheit in dem Phasenauswertungsblock bewirkt werden. Mit der ermittelten Phasendifferenz ist es anschließend problemlos möglich, in einem der beiden Kanäle eine Korrektur genau dieser Phasendifferenz durchzuführen.

Der Phasenkorrekturwert kann mit Vorteil im Phasenauswertungsblock abgespeichert werden, damit der Korrekturwert auch nach der Kalibrier-Betriebsart in einem Normalbetrieb zur Verfügung steht.

Dadurch, daß zur Phasenkorrektur keine externen Bauteile benötigt werden, ist die Implementierung der vorgeschlagenen Energiezähleranordnung mit Vorteil sehr kostengünstig möglich. Daher ist die vorgeschlagene, integrierbare Energiezähleranordnung besonders gut für eine Massenherstellung geeignet.

Ein zusätzlicher Vorteil ist dadurch gegeben, daß die Zeit, die zur Kalibrierung der Energiezähleranordnung nach dem vorgeschlagenen Prinzip benötigt wird, besonders gering ist. Prinzipiell kann der Phasenunterschied zwischen den beiden Eingangskanälen innerhalb lediglich einer Periodendauer des Eingangssignals bestimmt werden. Die Periodendauer kann dabei in einfacher Weise aus dem Kehrwert der jeweiligen Signalfrequenz berechnet werden. Die Signalfrequenz bei Energiezählern beträgt üblicherweise 50 Hertz oder 60 Hertz, je nach nationaler Standardisierung.

Gemäß dem vorgeschlagenen Prinzip wird eine Phasenabweichung zwischen den als Analogsignale vorliegenden Eingangssignalen der Energiezähleranordnung erfaßt. Die Korrektur des Phasenfehlers erfolgt hingegen im Bereich der digitalen Signalverarbeitung, nämlich nach der Analog-/Digital-Wandlung der Eingangssignale.

Um eine besonders schnelle Ermittlung der Phasenabweichung zwischen den Eingangskanälen der Energiezähleranordnung zu erzielen, ist es vorteilhaft, den Takteingang des Phasenauswertungsblocks mit den Takteingängen der Analog-/DigitalWandler zu verbinden und so für die Phasenauswertung das Taktsignal der Analog-/Digital-Wandler mit zu verwenden, das ohnehin zum Betrieb der Energiezähleranordnung benötigt wird.

Der Phasenauswertungsblock umfaßt mit Vorteil Mittel zum dauerhaften Speichern eines Phasenkorrekturwertes. Das Mittel zum dauerhaften Speichern eines Phasenkorrekturwertes ist bevorzugt als nicht-flüchtiger Speicher, beispielsweise als EEPROM, ausgebildet.

Durch das dauerhafte Speichern des Phasenkorrekturwertes steht der in einer Kalibrierbetriebsart ermittelte Phasenkorrekturwert auch noch nach einem Aus- und Wiedereinschalten der Energiezähleranordnung zur Verfügung.

Zur Signalaufbereitung der dem Phasenauswertungsblock zuzuführenden Eingangssignale ist es vorteilhaft, je einen begrenzenden Verstärker vorzusehen, der den ersten Eingang und den zweiten Eingang der Energiezähleranordnung mit zugeordneten Eingängen des Phasenauswertungsblocks koppelt.

Die Analog-/Digital-Wandler sind mit Vorteil jeweils als Sigma-Delta-Wandler oder als Sigma-Delta-Modulator ausgebildet. Dadurch ist eine Abtastung der Eingangssignale, die von Spannung und Strom abgeleitet sind, mit hoher Auflösung bei guter Integrierbarkeit möglich.

Am Ausgang des Multiplizierers ist mit Vorteil ein Integrator vorgesehen, der das vom Multiplizierer bereitgestellte Signal integriert. Der Integrator kann mit Vorteil als Akkumulator ausgebildet sein.

Der Integrator ist mit Vorteil so ausgelegt, daß er das vom Multiplizierer bereitgestellte Signal, welches die momentane elektrische Leistung repräsentiert, zu einem Signal integriert, welches ein Maß für die verbrauchte oder erzeugte elektrische Energie ist.

Weiter bevorzugt sind der erste und der zweite Analog-/Digital-Wandler, der Phasenkorrekturblock und der Phasenauswertungsblock in integrierter Schaltungstechnik ausgebildet. Auch die begrenzenden Verstärker, die Sigma-Delta-Wandler sowie weitere Funktionsblöcke und/oder Bauteile in der Signalverarbeitungskette der Energiezähleranordnung können, soweit vorhanden, mit Vorteil in integrierter Schaltungstechnik ausgebildet sein. Die Energiezähleranordnung kann mit Vorteil in einem einzigen integrierten Halbleiterschaltkreis implementiert sein.

Am ersten Eingang der Energiezähleranordnung und/oder am zweiten Eingang der Energiezähleranordnung kann mit Vorteil der Ausgang eines Übertragers angeschlossen sein, der eine galvanische Trennung bewirkt. Ein derartiger, nichtgalvanischer Übertrager kann mit Vorteil ein Transformator sein.

Die verhältnismäßig großen Phasenabweichungen derartiger Koppelglieder, welche eine galvanische Trennung der Eingänge bewirken, können mit dem vorgeschlagenen Prinzip in besonders einfacher und wirkungsvoller sowie hochgenauer Weise kompensiert werden.

Bevorzugt ist ein Mittel zur Erzeugung eines Testsignals vorgesehen, das mit dem ersten und dem zweiten Eingang der Energiezähleranordnung gekoppelt ist.

Soweit Einkoppelglieder vorgesehen sind, wie beispielsweise transformatorische Übertrager, ist das Mittel zur Erzeugung des Testsignals mit Vorteil so ausgebildet, daß das Testsignal am Eingang des Übertragers bzw. Einkoppelgliedes eingespeist wird. Dabei kann es vorteilhaft sein, eine Umschaltbarkeit der Eingänge zwischen einer Nutzsignalbetriebsart und einer Kalibrierbetriebsart, in der die Eingänge mit dem Mittel zur Erzeugung des Testsignals verbunden sind, vorzusehen.

Das Mittel zur Erzeugung des Testsignals kann mit Vorteil in einer Kalibrierbetriebsart aktivierbar sein, während es in der Normal-Betriebsart, das heißt in dem eigentlichen Energie-Meßbetrieb, deaktiviert werden kann.

Weitere Einzelheiten und vorteilhafte Ausgestaltungen des vorgeschlagenen Prinzips sind Gegenstand der Unteransprüche.

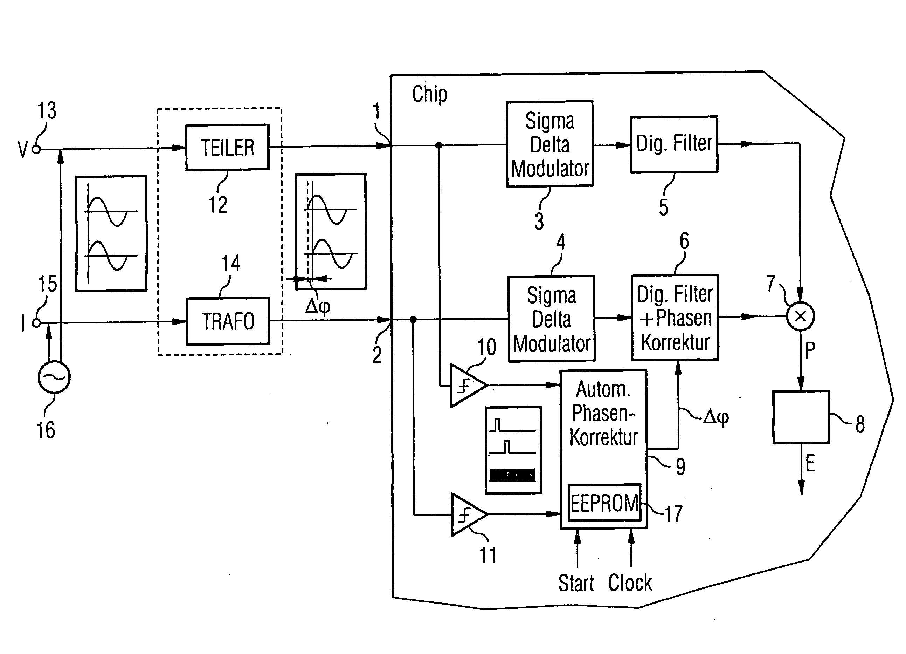

Die Erfindung wird nachfolgend an einem Ausführungsbeispiel anhand der Figur näher erläutert.

Es zeigt:
- die Figur: ein Blockschaltbild eines Ausführungsbeispiels der vorgeschlagenen Energiezähleranordnung.

Die Figur zeigt eine Energiezähleranordnung mit einem ersten Eingang 1 und einem zweiten Eingang 2. Der erste Eingang 1 ist ausgelegt zum Zuführen eines von einer elektrischen Spannung V abgeleiteten Signals. Der zweite Eingang 2 ist ausgelegt zum Zuführen eines von einem elektrischen Strom I abgeleiteten Signals. Dabei sind die elektrische Spannung V und der elektrische Strom U auf das gleiche Signal bezogen. An den ersten Eingang 1 ist der Eingang eines ersten Analog-/Digital-Wandlers 3 angeschlossen. An den zweiten Eingang 2 ist der Eingang eines zweiten Analog-/Digital-Wandlers 4 angeschlossen. Die Analog-/Digital-Wandler 3, 4 sind jeweils als Sigma-Delta-Modulator ausgeführt. Der Ausgang des ersten Analog-/Digital-Wandlers 3 ist über ein erstes digitales Filter 5 mit dem Eingang eines Multiplizierers 7 verbunden. Der Ausgang des zweiten Analog-/Digital-Wandlers 4 ist über ein zweites digitales Filter 6 mit einem weiteren Eingang des Multiplizierers 7 verbunden. Das zweite digitale Filter 6 umfaßt einen Phasenkorrekturblock. An den Ausgang des Multiplizierers 7 ist ein Integrator 8 angeschlossen, der ein an seinem Eingang anliegendes Signal, welches ein Maß für die momentane elektrische Leistung P ist, in ein Signal konvertiert, welches die elektrische Energie E repräsentiert. Weiterhin ist ein Phasenauswertungsblock 9 mit einem ersten Eingang und einem zweiten Eingang vorgesehen. Mit je einem begrenzenden Verstärker 10, 11 sind der erste Eingang und der zweite Eingang 1, 2 der Energiezähleranordnung mit den Eingängen des Phasenauswertungsblockes 9 verbunden.

Der Phasenauswertungsblock 9 umfaßt einen nicht-flüchtigen Speicher 17, in dem die gemessene Phasenabweichung oder der zugehörige Korrekturwert dauerhaft gespeichert werden können.

Zur Auskopplung der elektrischen Spannung ist ein Spannungsteiler 12 vorgesehen, dessen Ausgang mit dem ersten Eingang der Energiezähleranordnung verbunden ist und dessen Eingang einen Spannungseingang 13 zur Zuführung der elektrischen Spannung bildet. Zur Auskopplung des elektrischen Stroms ist ein Transformator 14 vorgesehen, der zwischen einen Stromeingang 15 und den zweiten Eingang 2 der Energiezähleranordnung geschaltet ist. Der Transformator 14 stellt eine galvanische Entkopplung zwischen dem Stromeingang 15 und dem zweiten Eingang 2 bereit.

An den Spannungseingang 13 und den Stromeingang 15 ist der Ausgang eines Testsignalgenerators 16 angeschlossen. Der Testsignalgenerator 16 stellt ein harmonisches, beispielsweise sinusförmiges Signal mit einer Nennfrequenz von 50 oder 60 Hertz bereit.

Durch den Spannungsteiler 12 und den Transformator 14 ergeben sich für die beiden Eingangskanäle des Energiezählers unterschiedliche Phasenverschiebungen. Von besonderer Bedeutung ist der relative Phasenunterschied Δϕ zwischen den beiden Eingangskanälen an den Eingängen 1, 2 der Energiezähleranordnung. Diese Phasenabweichung Δϕ wird mit dem Phasenauswertungsblock 9 ermittelt. Dies erfolgt in einer Kalibrier-Betriebsart dadurch, daß der Testsignalgenerator 16 aktiviert wird und demnach an dem Spannungseingang 13 und dem Stromeingang 15 jeweils ein phasengleiches, sinusförmiges Signal einspeist. Dieses Signal erfährt in dem Spannungsteiler 12 und dem Transformator 14 eine unterschiedliche Phasenverschiebung.

Die relative Phasenabweichung Δϕ an den Eingängen 1, 2 wird in dem Phasenauswertungsblock dadurch ermittelt, daß die Zeitspanne zwischen den Null-Durchgängen der beiden Signale an den Eingängen des Phasenauswertungsblockes erfaßt und in eine korrespondierende Phasenabweichung umgerechnet wird. Ein entsprechender Korrekturwert wird am Ausgang des Phasenauswertungsblockes abgegeben. Damit wird ein Phasenkorrekturblock im digitalen Filter 6 angesteuert, der den Phasenunterschied Δϕ gerade ausgleicht. Die begrenzenden Verstärker 10, 11 verbessern dabei die Genauigkeit der Erkennung der Null-. Durchgänge.

Die Kalibrierbetriebsart wird einmalig bei der Herstellung der Energiezähleranordnung aktiviert.

Mit dem vorgeschlagenen Prinzip wird eine automatische Phasenkorrektur für integrierte Energiezähleranordnungen bereitgestellt, welche vollständig integriert ist. Die vorgeschlagene Energiezähleranordnung zeichnet sich außerdem durch eine geringe Kalibrierzeit sowie geringe Kosten bei der Herstellung aus. Zudem ist eine galvanische Isolierung zumindest eines Kanals am Eingang der Energiezähleranordnung möglich, ohne daß dadurch Meßfehler auftreten. Die galvanische Isolierung ist besonders dann von hoher Bedeutung, wenn mehr als ein Kanal gemessen wird, wie bei elektrischen Energiezählern üblich.

Insbesondere kann eine Phasenverschiebung, welche von Transformatoren unvermeidbar verursacht wird, kompensiert werden. Dabei werden keine zusätzlichen externen Komponenten wie Widerstands-Kapazitätsnetzwerke zur Phasenkorrektur benötigt.

Durch den nicht-flüchtigen Speicher 17 steht der Phasenkorrekturwert auch noch dann bereit, wenn der Energiezähler abgeschaltet ist.

Da die Bestimmung der Phasenabweichung grundsätzlich innerhalb einer Periodendauer möglich ist, kann mit dem vorgeschlagenen Prinzip eine besonders schnelle Kalibrierung vorgenommen werden.

Der Phasenauswertungsblock 9 hat mit Vorteil einen Takteingang, der mit den Takteingängen der Sigma-Delta-Modulatoren 3, 4 verbunden ist. Dadurch können die Taktflanken zwischen zwei Null-Durchgängen an den Eingängen 1, 2 gezählt und so die Phasenabweichung in einfacher und genauer Weise ermittelt werden.

Gemäß dem vorgeschlagenen Prinzip wird im analogen Signalereich eine Erfassung der relativen Phasenabweichung an den beiden Eingängen der Energiezähleranordnung durchgeführt. Die Korrektur der Phasenabweichung erfolgt jedoch in der digitalen Signalverarbeitung.

## Patentansprüche

1. Energiezähleranordnung, aufweisend
- einen ersten Eingang (1) zum Zuführen eines von einer Spannung (V) abgeleiteten Signals, an den ein erster Analog/Digital-Wandler (3) angeschlossen ist,
- einen zweiten Eingang (2) zum Zuführen eines von einem Strom (I) abgeleiteten Signals, an den ein zweiter Analog/Digital-Wandler (4) angeschlossen ist,
- einen Multiplizierer (7), der die Ausgänge der beiden Analog/Digital-Wandler (3, 4) miteinander verknüpft,
- Phasenkorrekturblock (6), der zwischen einen Ausgang eines der beiden Analog/Digital-Wandler (4) und den Multiplizierer (7) gekoppelt ist, ausgelegt zur Korrektur einer Phasenabweichung (Δϕ) des digitalisierten, von dem Strom (I) oder der Spannung (V) abgeleiteten Signals,
**dadurch gekennzeichnet, daß** die Energiezähleranordnung ferner aufweist
- einen Phasenauswertungsblock (9) mit zwei Eingängen, die mit dem ersten und dem zweiten Eingang (1, 2) der Energie-zähleranordnung zur Messung der Phasenabweichung (Δϕ) im analogen Signalbereich auf der Basis des von der Spannung (V) abgeleiteten Signals und des von dem Strom (I) abgeleiteten Signals gekoppelt sind, und mit einem Ausgang, der mit dem Phasenkorrekturblock (6) gekoppelt ist, und
- je einen begrenzenden Verstärker (10, 11), der je einen Eingang (1, 2) der Energiezähleranordnung mit je einem Eingang des Phasenauswertungsblocks (9) koppelt.

2. Energiezähleranordnung nach Anspruch 1,
**dadurch gekennzeichnet, daß**
der Phasenauswertungsblock (9) Mittel zum dauerhaften Speichern eines Phasenkorrekturwertes (17) umfaßt.

3. Energiezähleranordnung nach Anspruch 1 oder 2,
**dadurch gekennzeichnet, daß**
der erste und der zweite Analog/Digital-Wandler (3, 4) jeweils als Sigma-Delta-Wandler ausgebildet sind.

4. Energiezähleranordnung nach einem der Ansprüche 1 bis 3,
**dadurch gekennzeichnet, daß** diese
einen Integrator (8) umfasst, der dem Multiplizierer (7) nachgeschaltet ist.

5. Energiezähleranordnung nach einem der Ansprüche 1 bis 4,
**dadurch gekennzeichnet, daß**
der erste und der zweite Analog/Digital-Wandler (3, 4), der Phasenkorrekturblock (6) und der Phasenauswertungsblock (9) in integrierter Schaltungstechnik ausgebildet sind.

6. Energiezähleranordnung nach einem der Ansprüche 1 bis 5,
**dadurch gekennzeichnet, daß**
am ersten Eingang (1) und/oder am zweiten Eingang (2) ein nicht-galvanisch koppelnder Übertrager (14) zur Einkopplung des von einer Spannung (V) und/oder von einem Strom (I) abgeleiteten Signals angeschlossen ist.

7. Energiezähleranordnung nach Anspruch 6,
**dadurch gekennzeichnet, daß**
der nicht-galvanisch koppelnde Übertrager (14) als Transformator ausgebildet ist.

8. Energiezähleranordnung nach einem der Ansprüche 1 bis 7,
**dadurch gekennzeichnet, daß** diese
ein Mittel zur Erzeugung eines Testsignals (16) umfasst, das mit dem ersten und dem zweiten Eingang (1, 2) der Energiezähleranordnung gekoppelt ist.

## Claims

1. An energy meter device, comprising
- a first input (1) for supplying a signal derived from a voltage (V), a first analog/digital converter (3) being connected to the first input,
- a second input (2) for supplying a signal derived from a current (I), a second analog/digital converter (4) being connected to the second input,
- a multiplier (7) linking the outputs of the two analog/digital converters (3, 4) to each other,
- a phase correction block (6) coupled between an output of one of the two analog/digital converters (4) and the multiplier (7), designed for correcting a phase deviation (Δϕ) of the digitalized signal derived from the current (I) or the voltage (V),
**characterized in that** the energy meter device further comprises
- a phase evaluation block (9) comprising two inputs which are coupled to the first and second inputs (1, 2) of the energy meter device for measuring the phase deviation (Δϕ) in the analog signal domain on the basis of the signal derived from the voltage (V) and the signal derived from the current (I), and comprising an output which is coupled to the phase correction block (6), and
- a limiting amplifier (10, 11) in each case, coupling each of the inputs (1, 2) of the energy meter device to one input of the phase evaluation block (9).

2. The energy meter device according to claim 1,
**characterized in that**
the phase evaluation block (9) comprises means for permanently storing a phase correction value (17).

3. The energy meter device according to claim 1 or 2,
**characterized in that**
the first and second analog/digital converters (3, 4) are each designed as a sigma-delta-converter.

4. The energy meter device according to any of the claims 1 to 3,
**characterized in that** it comprises an integrator (8) which is arranged downstream of the multiplier (7).

5. The energy meter device according to any of the claims 1 to 4,
**characterized in that**
the first and second analog/digital converters (3, 4), the phase correction block (6) and the phase evaluation block (9) are realized in integrated circuit technology.

6. The energy meter device according to any of the claims 1 to 5,
**characterized in that**
a non-galvanically coupling converter (14) is connected to the first input (1) and/or the second input (2) for injecting the signal derived from a voltage (V) and/or a current (I).

7. The energy meter device according to claim 6,
**characterized in that**
the non-galvanically coupling converter (14) is realized as a transformer.

8. The energy meter device according to any of the claims 1 to 7,
**characterized in that**
it comprises means for generating a test signal (16) which is coupled to the first and second inputs (1, 2) of the energy meter device.

## Revendications

1. Dispositif de comptage d'énergie, présentant
- une première entrée (1) destinée à amener un signal dérivé d'une tension (V), à laquelle un premier convertisseur analogique-numérique (3) est raccordé,
- une deuxième entrée (2) destinée à amener un signal dérivé d'un courant (I), à laquelle un deuxième convertisseur analogique-numérique (4) est raccordé,
- un multiplicateur (7) qui relie entre elles les sorties des deux convertisseurs analogiques-numériques (3, 4),
- un bloc de correction de phase (6) qui est couplé entre une sortie d'un des deux convertisseurs analogiques-numériques (4) et le multiplicateur (7), conçu pour corriger un écart de phase (Δϕ) du signal numérisé dérivé du courant (I) ou de la tension (V),
**caractérisé en ce que** le dispositif de comptage d'énergie présente en outre
- un bloc d'évaluation de phase (9) comprenant deux entrées qui sont couplées à la première et la deuxième entrée (1, 2) du dispositif de comptage d'énergie pour la mesure de l'écart de phase (Δϕ) dans la plage de signal analogique sur la base du signal dérivé de la tension (V) et du signal dérivé du courant (I), et comprenant une sortie qui est couplée au bloc de correction de phase (6), et
- respectivement un amplificateur limitateur (10, 11) qui couple respectivement une entrée (1, 2) du dispositif de comptage d'énergie à respectivement une entrée du bloc d'évaluation de phase (9).

2. Dispositif de comptage d'énergie selon la revendication 1,
**caractérisé en ce que**
le bloc d'évaluation de phase (9) comporte des moyens d'enregistrement durable d'une valeur de correction de phase (17).

3. Dispositif de comptage d'énergie selon la revendication 1 ou 2,
**caractérisé en ce que**
le premier et le deuxième convertisseur analogique-numérique (3, 4) sont constitués respectivement comme convertisseurs sigma-delta.

4. Dispositif de comptage d'énergie selon l'une des revendications 1 à 3,
**caractérisé en ce que** celui-ci
comporte un intégrateur (8) qui est monté en aval du multiplicateur (7).

5. Dispositif de comptage d'énergie selon l'une des revendications 1 à 4,
**caractérisé en ce que**
le premier et le deuxième convertisseur analogique-numérique (3, 4), le bloc de correction de phase (6) et le bloc d'évaluation de phase (9) sont constitués selon la technique de connexion intégrée.

6. Dispositif de comptage d'énergie selon l'une des revendications 1 à 5,
**caractérisé en ce que**
un transmetteur (14) à couplage non galvanique est raccordé au niveau de la première entrée (1) et/ou de la deuxième entrée (2) pour le couplage du signal dérivé d'une tension (V) et/ou d'un courant (I).

7. Dispositif de comptage d'énergie selon la revendication 6,
**caractérisé en ce que**
le transmetteur (14) à couplage non galvanique est constitué comme transformateur.

8. Dispositif de comptage d'énergie selon l'une des revendications 1 à 7,
**caractérisé en ce que** celui-ci
comporte un moyen de production d'un signal de test (16) qui est couplé à la première et à la deuxième entrée (1, 2) du dispositif de comptage d'énergie.
